# EUROPEAN PATENT APPLICATION

(11) **EP 4 390 540 A1**
(43) Date of publication of application: **26.06.2024**
(21) Application number: 22214530.2
(22) Date of filing: 19.12.2022
(51) Int. Cl.: G03F 7/00, G03F 9/00

(54) **ALIGNMENT METHOD**

(71) Applicant: Koninklijke Philips N.V., 5656 AG Eindhoven (NL)
(72) Inventor: VERSCHUUREN, Marcus Antonius, 5656 AG Eindhoven (NL); ARLT, Christian Alfred, 5656 AG Eindhoven (NL)
(74) Representative: Philips Intellectual Property & Standards

(57) **Abstract**

A mechanism for aligning a stamp and a substrate during a substrate conformal imprint lithography (SCIL) process. A stamp marker, comprising a first diffraction grating, is positioned on the stamp and a substrate marker is positioned on the substrate. The two markers are illuminated with two different lights. Each marker is configured to redirect proportionally more of a respective form of light (received by said marker) towards a light sensor than the other marker.

## Description

### FIELD OF THE INVENTION

The present invention relates to the field of aligning a stamp and a substrate in an imprint lithography process.

### BACKGROUND OF THE INVENTION

In imprint lithography a stamp with a relief surface is used to pattern a substate layer. A substrate carrying a moldable imprint composition layer at its surface is brought in contact with the relief surface of the stamp such that the moldable layer conforms to the relief of the stamp. During contact the moldable layer is solidified, also often referred to as "cured", after which the stamp is removed from the substrate leaving a relief pattern of molded material with a pattern complementary to that of the stamp on the substrate.

One type of imprint lithography makes use of flexible stamps, for example, made of elastomeric materials such as rubber polymers. Such stamps are sometimes referred to as "soft stamps" and the lithography concomitantly is sometimes referred to as "soft lithography". Substrate Conformal Imprint Lithography ("SCIL^{™} ") is one such soft stamp technology.

The manufacture of multilayer devices, such as for example semiconductor devices, generally requires lateral alignment of the device layers. To make imprint lithography and in particular soft stamp imprint lithography useful for the manufacture of multi patterned layer devices, there is a need for improved lateral alignment of stamp and substrate.

### SUMMARY OF THE INVENTION

The current invention aims at improving the alignment process for an imprint process using a flexible stamp. While in non-contact lithographic processes alignment can be done with lithographically made optical markers this has disadvantages for imprint lithography. The inventors have found that with (soft stamp) imprint lithography it is beneficial to have alignment markers in the stamp in the form of diffraction markers. It has also been found however that such markers provide reduced contrast when compared to markers on the substrate which makes alignment of both markers difficult. The signals from a substrate marker and a stamp marker are generally detected simultaneously and therefore mixed and largely indistinguishable.

The invention is defined by the claims and aims to fulfill the aforementioned goal.

The disclosed solution exploits the fact that diffraction-based markers allow illumination under an angle such that a first or higher order reflective diffraction light is captured by the alignment sensor and used for the alignment. At the same time, any disturbing specular reflection of the substrate marker, which is much more intense than any reflective diffraction light from the stamp marker, is not captured by the sensor.

According a first aspect there is provided a method of determining alignment between a stamp and a substrate in an imprint process as defined in claim 1. The stamp comprises a stamp marker comprising a first diffraction grating, having a first period, on a surface of the stamp and the substrate comprises a substrate marker on the surface of the substrate.

The combination of the first light and the stamp marker and the combination of the first light and the substrate marker have different angles for maxima and minima of light intensities directed to the sensor. The combination of the stamp marker and the first light may result in a maxima at the light sensor. In contrast, the combination of the first light and the substrate marker may result in less than a maxima at the light sensor. The combination of the first light and the substrate marker may preferably result in minima, or close to a minima.

Similarly, the combination of the second light and the substrate marker and the second light and the stamp marker have different angles for maxima and minima of light intensities directed to the sensor. The combination of the substrate marker and the second light may result in a maxima at the light sensor whereas the combination of the second light and the stamp marker may result in less than a maxima at the light sensor.

In this way, the light used to detect the stamp marker may not be (substantially) redirected by the substrate marker to the light sensor. Similarly, the light used to detect the substrate marker may not be (substantially) redirected by the stamp marker to the light sensor.

Put another way, the light sensor can distinguish light redirected from only the stamp marker or the substrate marker. An improved detection of both markers is therewith provided.

In this way the lateral position of the substrate can be determined without the signal being substantially affected by the stamp marker and the lateral position of the stamp can be determined without being substantially affected by the substrate marker.

The difference between the first and second fraction is preferably as great as possible but may be at least five times greater than the second fraction or at least two times greater than the second fraction. Similarly, the difference between the third fraction and the fourth fraction is preferably as great as possible but may be at least five times greater than the fourth fraction or at least two times greater than the second fraction.

The substrate marker may comprise a diffraction grating (i.e., a second diffraction grating) with a second period. The first period and the second period are preferably different and preferably the larger of the first period and the second period is at least 20% greater than the smaller of the first period and the second period. The use of different periods results in different maxima and minima angles for each of the diffraction gratings. The first period may be less than the second period.

Illuminating the substrate marker with the second light may comprise illuminating the substrate marker with light having a wavelength and incident angle such that light at the first or higher diffraction order is incident upon the light sensor. The use of higher diffraction orders results in a better defined marker position. Thus, preferably third or higher order diffraction orders are incident upon the light sensor.

The step of illuminating the stamp marker with a first light may comprise illuminating the stamp marker with light having a wavelength and incident angle such that light at the first or higher diffraction order is incident upon the light sensor. In some examples, the step of illuminating the stamp marker with a first light comprises illuminating the stamp marker with light having a wavelength and incident angle such that light at the third or higher diffraction order is incident upon the light sensor.

In some examples, the diffraction order used for the stamp marker may differ from the diffraction order used for the substrate marker.

The first light has a peak intensity at a first wavelength and the second light has a peak intensity at a second, different wavelength. In some examples, the larger of the first wavelength and the second wavelength is at least 20% greater than the smaller of the first wavelength and the second wavelength.

The step of illuminating at least the stamp marker with the first light is preferably performed at a different time from the step of illuminating at least the substrate marker with the second light. As different wavelengths of light and possibly different diffraction orders are used even different maxima may have different intensities. Consequently, the step of illuminating at least the stamp marker with the first light is performed for a first period of time and the step of illuminating at least the substrate marker with the second light is performed for a second period of time and the lengths of the first period of time and the second period of time may be different.

According to some examples of the invention the substrate marker is a contrast marker configured to reflect a portion of the second light to the light sensor. Thus, the invention can be used in conjunction with both diffraction markers and contrast markers as substrate markers.

The light sensor may be an image sensor and the step of using the response of the light sensor to determine an alignment between the stamp and the substrate may comprise determining the alignment by processing the image at the image sensor from the first light and the image at the image sensor from the second light.

There is also proposed a lithographic process comprising any herein described method of determining alignment. The lithographic process may comprise aligning the substrate and stamp, imprinting the pattern on the substrate or a substance thereon, and etching the substrate. These processes may be repeated may times, and each repetition may have a different pattern.

According to a second aspect there is provided an alignment system for determining an alignment between a stamp and a substrate in an imprint process as claimed in claim 14. The stamp comprises a stamp marker comprising a first diffraction grating, having a first period, on a surface of the stamp and the substrate comprises a substrate marker on the surface of the substrate.

There is a processing system communicatively coupled to the light sensor and configured to use or process the response of the light sensor caused by the directed first light and directed second light to determine an alignment between the stamp and the substrate.

The processing system of the alignment system may be configured to control the operation of the lighting system and/or the light sensor to control the alignment system in performing the defined functions.

According to a third aspect there is provided a computer program product comprising computer program code means which, when executed by the alignment system of as described above, causes the alignment system to perform the steps of the method as described above.

These and other aspects of the invention will be apparent from and elucidated with reference to the embodiment(s) described hereinafter.

### BRIEF DESCRIPTION OF THE DRAWINGS

For a better understanding of the invention, and to show more clearly how it may be carried into effect, reference will now be made, by way of example only, to the accompanying drawings, in which:
Figs. 1A and 1B show cross sectional views of an imprinting process;
Fig. 2A depicts a stamp according to the invention;
Fig. 2B depicts a substrate according to the invention;
Fig. 3A depicts alignment between a stamp and a substrate;
Fig. 3B depicts alignment between a stamp and a substrate;
Figs. 4A, 4B and 4C depict the illumination of markers;
Fig. 5A depicts a stamp marker;
Fig. 5B depicts a substrate marker;
Fig. 5C depicts illumination according to the invention;
Fig. 6 depicts the illumination of a reflection substrate marker;
Fig. 7 depicts a method according to the invention;
Fig. 8 depicts an apparatus according to the invention; and
Fig. 9 is a simplified block diagram of a computer within which one or more parts of an embodiment may be employed.

### DETAILED DESCRIPTION OF THE EMBODIMENTS

The invention will be described with reference to the Figures.

The detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. The mere fact that certain measures are recited in mutually different dependent claims does not indicate that a combination of these measures cannot be used to advantage.

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality.

The Figures are merely schematic and are not drawn to scale. The same reference numerals are used throughout the Figures to indicate the same or similar parts.

Embodiments propose a mechanism for aligning a stamp and a substrate during an imprint process such as for example a substrate conformal imprint lithography (SCIL) process. A stamp marker, comprising a first diffraction grating, is positioned on the stamp and a substrate marker is positioned on the substrate. The two markers are illuminated with two different lights. Each marker is configured to redirect proportionally more of one form of light (received by said marker) towards a light sensor than the other marker.

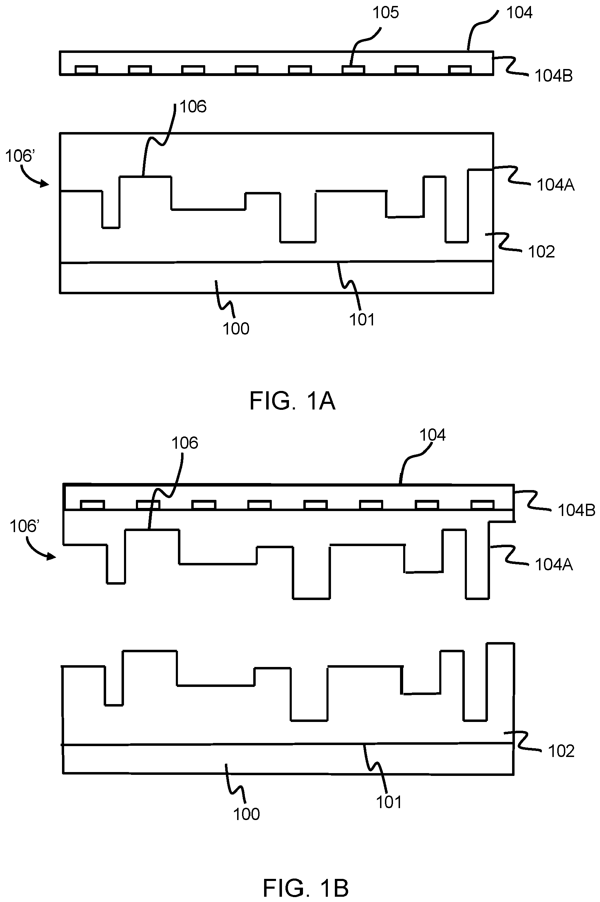

Figs. 1A and 1B illustrate a fabrication process for the purposes of improved contextual understanding.

Known processes for fabrication of microdevices comprise successive application of device layers to a substrate. A typical process cycle for applying such a device layer comprises deposition of a layer of desired material, for example, an insulator or (semi)conductor, followed by structuring, or so called patterning of the applied layer.

In the present disclosure, the structuring of the material layer is done using an imprinting or embossing method. This process includes (during a cycle of steps) a procedure of applying a material layer 102 to a surface 101 of a substrate 100, for example, by way of droplets using inkjet printing, or uniformly dispersal using spincoating or a doctor blade technique over the substrate surface 101. The applied material layer 102 is formable. This material layer 102 is brought into contact with a stamp 104 having a relief surface 106 representing a pattern 106' that needs to be replicated in or imaged into the material layer 102 (Fig. 1A) so that the stamp imprints the shape of the relief surface onto the material layer 102.

During the time in which the stamp 104 is in contact with the material layer 102, the material layer first adopts the shape of the relief surface 106 of the pattern 106' and then is hardened beyond (re)formability using some curing process. Example curing processes use chemical reactions to solidify the layers under application of heat or radiation, or by solvent removal from the layer as described in the European Patent Applications having publication numbers EP 2,087,403 A2 and EP 2,091,666 A2 as well as in references cited therein. After removal of the stamp 104 from the material layer 102, a formed relief material layer remains that has the relief surface 108 representing the complementary pattern 108 of the pattern 106' (Fig. 1B). This formed material layer may serve as a base for patterning a substrate layer using some etching process, or it may serve as a patterned device layer directly with or without further modification or processing.

In general, in devices having multiple stacked device layers, the pattern of one device layer needs to be laterally aligned with that of one or more other such layers or the base substrate. Hence, during application of a new device layer an alignment step is also performed. In the exemplary process as described here above, this means that the alignment step must be performed before the stamp 104 is brought into contact with the material layer 102, since when they are in contact lateral repositioning of the substrate 100 and stamp 104 is difficult or impossible, or could result in dragging or unwanted deformation of the material layer 102.

The illustrated stamp 104 comprises two portions: a conformable relief portion 104A and a glass plate 104B. The relief portion is used to imprint the material layer 102, and may be formed from a transparent polymer. The glass plate is rigid and comprises at least one groove 105. An under pressure is applied to the groove so that the relief portion is held securely by the glass plate.

Successive layers of a semiconductor substrate 100 must be correctly aligned with each other for a resulting to device to function. If layers are not correctly aligned then signals will not be transmitted between the layers and the device will not function correctly. The substrate comprises one or more markers and the conformable relief portion of the stamp 104 also comprises one or more markers. For correct alignment of stamp with the substrate, and any underlying patterned layers of the stamp, the marker of the stamp and the marker on the substrate should be correctly aligned.

The marker of the stamp is generally arranged on the conformable relief portion as this is the portion in which the pattern to be imprinted is formed, and the alignment between the relief portion 104A and the glass plate 104B may be inexact.

The present disclosure relates to improved approaches for aligning the stamp with the substrate. The following description provides a descriptive understanding of embodiments.

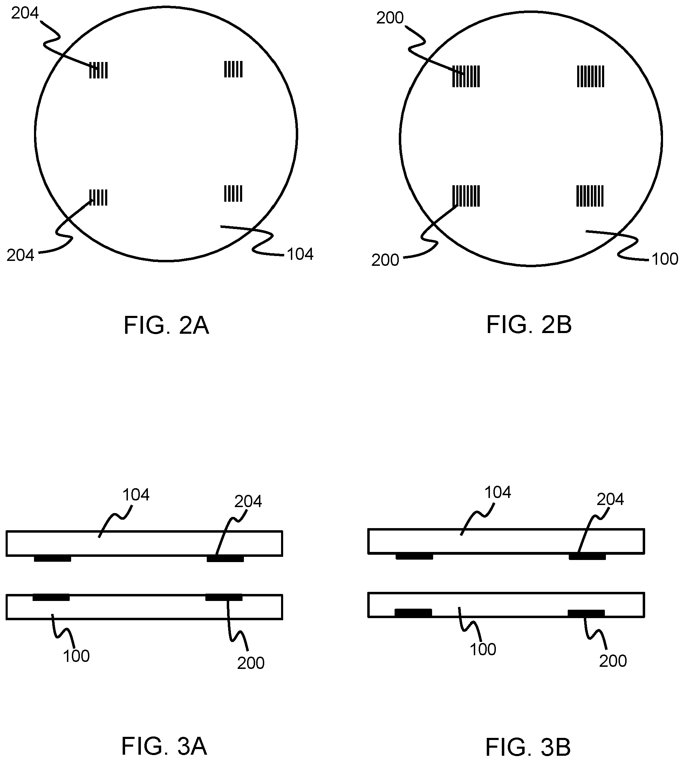

As illustrated in Fig. 2A, the stamp, e.g., the conformable relief portion of the stamp, comprises a stamp marker in the form of a diffraction grating 204. The stamp may comprise a plurality of diffraction gratings, i.e., markers, which may be positioned on the conformable relief portion.

As illustrated in Fig. 2B, the substrate 100 may comprise a substrate marker, e.g., in the form of a diffraction grating 200. There may be a plurality of substrate markers (e.g., diffraction gratings), arranged at different locations on the substrate such that the substrate and the stamp can be aligned both laterally and rotationally.

Alternatively, the substrate marker may be in the form of a reflective or contrast marker configured to reflect light. Suitable embodiments will be described more completely below.

Figs. 3A and 3B illustrate alternative positions for the markers 200 on the substrate. The markers 200 on the substrate 100 may be located on the front of the substrate, as depicted in Fig. 3A or the back of the substrate 100, as depicted in Fig. 3B. Other suitable arrangements will be apparent to the skilled person.

The alignment between the substrate 100 and the stamp 104 uses optical processes so optical imperfections can inhibit the alignment process.

The glass plate of the stamp 104 may comprise grooves used to apply an underpressure to the conformable relief portion to adhere it to the glass plate. The use of a plurality of markers on both the substrate 100 and the stamp 104 means that, even if one or more of the markers is located in the vicinity of a groove the alignment can proceed using markers not impacted by the grooves.

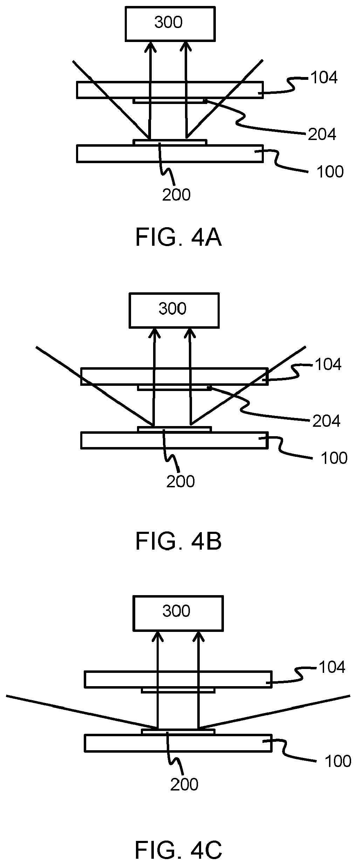

Fig. 4A depicts part of an alignment process in which the substrate marker 200 is illuminated. The substrate marker 200, comprising a diffraction grating with a period Λ, diffracts some light towards the light sensor 300. In a working example, the third diffraction order is redirected towards the light sensor 300. However, it may be the first, second or any higher diffraction order which is diffracted towards the light sensor 300.

The wavelength of the illumination light and the period of the diffraction grating both affect the angle of redirection, as shown and described in conjunction with Figs. 4B and 4C. In Fig. 4B a longer wavelength is used and, as can be seen a shallower incident angle is used to ensure the light is redirected towards the light sensor. In Fig. 4C, the diffraction grating has a shorter period A. Consequently a shallower angle of incident light is used to ensure the illuminating light is redirected towards the light sensor. The use of a shorter period and a shallower angle results in a higher degree of accuracy.

The detection of an intensity of light, redirected by a marker, indicates the (lateral) location of the marker. If light redirected by the substrate marker indicates a particular lateral location of a substrate marker and light redirected by the stamp marker indicates a particular lateral location of the stamp marker then the degree of alignment between the stamp and the substrate can be determined.

Redirected light incident on the light sensor is preferably perpendicular, or substantially perpendicular to the plane of the substrate 100 and stamp 204.

As can be seen from Figs. 4A, 4B and 4C, the light redirected from the substrate marker passes through the stamp marker. It has been recognized that if the stamp marker also redirects illuminating light towards the light sensor 300, then it can be difficult to distinguish between light redirected from the stamp marker 204 and the substrate marker 200. An inability to distinguish between light redirected from the stamp marker and light redirected from the substrate marker can inhibit the detection of alignment, or lack thereof, between the substrate 100 and the stamp 200. Moreover, if the stamp marker 204 is configured to redirect light that illuminates the substrate marker (and is redirected by said substrate marker), then the stamp marker may attenuate or otherwise modify the light redirected by the substrate marker, making identification of alignment more difficult.

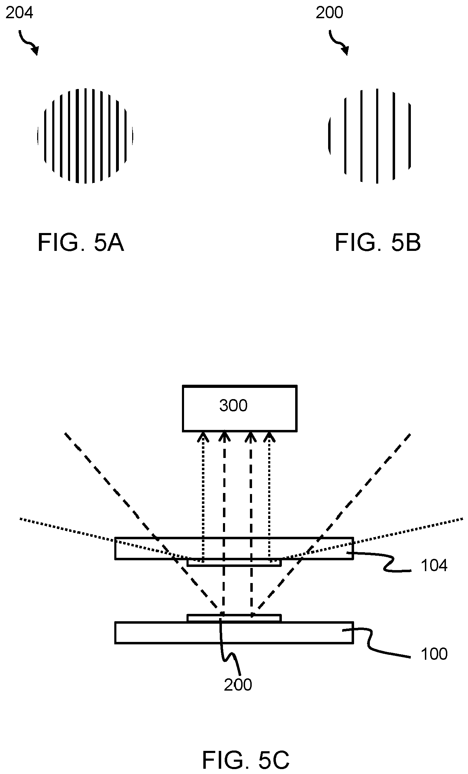

Fig. 5A depicts a stamp marker 204 and Fig. 5B depicts a substrate marker 200 for use in embodiments of the invention. As can be seen, both markers 204, 200 comprise diffraction gratings but the period of the diffraction grating of the stamp marker 204 is shorter/less than the period of the diffraction grating of the substrate marker 200.

Due to the different periods of the stamp marker(s) and substrate marker(s), illuminating light redirected by the substrate marker will have different angles of maxima from the same illuminating light redirected by the stamp marker 204. So, illuminating light may be directed by the substrate 200 towards the light sensor. However, the same illuminating light incident on the stamp marker 204 may have a minima at the image sensor 300. In this way, illuminating light can be used in the detection of the substrate marker 200 but, due to the different periodicities, no, or considerably reduced, light is redirected towards the light sensor 300 by the stamp marker 204.

This thereby provides a mechanism by which the fraction of received first light redirected by the stamp marker towards the light sensor is different to the fraction of received first light directed by the substrate marker towards the stamp marker. This same mechanism also results in the fraction of received second light redirected by the stamp marker towards the light sensor is different to the fraction of received second light directed by the substrate marker towards the stamp marker. The first light and second lights can be tuned or selected so that any received first light is redirected to the light sensor to a greater extent by any stamp marker, than any substrate marker, and so that any received second light is redirected to the light sensor to a greater extent by any substrate marker, than any stamp marker.

In one example embodiment, the stamp is illuminated with a first light, having a first wavelength λ₁, and incident at an angle θ₁ to the plane of the stamp such that the stamp marker 204, with a first period Λ₁, diffracts the light such that a diffraction order (e.g., the third diffraction order) is redirected towards the light sensor 300. Any of the first light, incident on the substrate marker 200, will also be diffracted but no maxima will be incident on the light sensor 300. So, the combination of the first light and the stamp marker 204 redirects a first fraction of the first light incident on the stamp marker to the light sensor. The combination of the first light and the substrate marker 200 redirects a second fraction of the first light incident on the substrate marker to the light sensor 300. The first fraction is at least twice the second fraction, and preferably at least five times the second fraction. Preferably, the combination of the first light and the stamp marker 204 results in a maxima being incident on the light sensor whereas the combination of the first light and the substrate marker 200 results in a minima being incident on the light sensor 300. Thus, when the stamp is illuminated by the first light and the light sensor detects a lateral position, it is the position of the stamp marker (and therefore the stamp 104) which is detected and not the substrate 100.

Just as the lateral position of the stamp marker 204 is detected using a first light, the lateral position of the substrate marker 200 is detected using a second light. The second light has a second wavelength λ₂ and is incident at an angle θ₂ to the substrate. The second light is such the substrate marker 200, with a second period Λ₂, diffracts a diffraction order (e.g., the third diffraction order) towards the image sensor. Any of the second light, incident on the stamp marker 200, will also be diffracted but may be configured such that no maxima will be incident on the light sensor 300. So, the combination of the second light and the substrate marker 200 redirects a third fraction of the second light incident on the substrate marker to the light sensor 300. The combination of the second light and the stamp marker 204 redirects a fourth fraction of the first light incident on the stamp marker to the light sensor 300. The third fraction is at least twice the fourth fraction, and preferably at least five times the fourth fraction. Preferably, the combination of the second light and the substrate marker 204 results in a maxima being incident on the light sensor whereas the combination of the second light and the stamp marker 200 results in a minima being incident on the light sensor 300. Thus, when the substrate is illuminated by the second light and the light sensor detects a lateral position, it is the position of the substrate marker (and therefore the substrate 100) which is detected and not the stamp 104.

Fig. 5C depicts both first and second lights illuminating the stamp and substrate.

Once the lateral position of the stamp 104 has been determined using the first light and the lateral position of the substrate 100 has been determined using the second light alignment between the stamp and substrate can be determined. If the stamp and substrate are not correctly aligned, or within a predetermined alignment, the lateral position of one or both of them can be adjusted accordingly. The alignment between the substrate and the stamp may then be determined again to check that the substrate and the stamp are aligned.

Although the example above illuminates the arrangement initially with a first light to determine the location of the stamp marker 204, followed by illumination by the second light to determine the location of the substrate marker 200, the skilled person will appreciate that the order of the first light and the second light is not important and the second light could equally be used before the first light. In summary, illumination by the first light is preferably at a different time from illumination by the second light.

The first light has a peak intensity at a first wavelength λ₁ and the second light has a peak intensity at a second wavelength λ₂. The first wavelength, λ₁ and the second wavelength λ₂ are preferably different. In some examples, the larger of the first wavelength and the second wavelength is at least 20% greater than the smaller of the first wavelength and the second wavelength.

Similarly, the first period Λ₁ and the second period Λ₂ are preferably different. The larger of the first period and the second period is preferably at least 20% greater than the smaller of the first period and the second period. Furthermore, the first period is preferably less than the second period.

Although the example above describes the third diffraction order as being incident on the light sensor 300 the apparatus can equally be configured such that the first order, second or any higher order is incident on the light sensor 300. Indeed, the combination of the first light and the stamp marker may result in nth order incident on the light sensor and the combination of the second light and the substrate marker 200 may result in the mth order incident on the light sensor, preferably where m≠n.

The stamp is illuminated by the first light for a first period of time and the substrate is illuminated by the second light for a second period of time. As the intensities of the diffracted light may be different depending on the diffraction order and other factors, the first period may be different from the second period. The intensity of the light at the light sensor during the first and second periods should be sufficient to determine the location of the stamp marker or the substrate marker respectively.

A different example of the invention will now be described in which the stamp marker 204 is a diffraction grating, but the substrate marker 200 is a contrast marker. Contrast markers operate in reflection and may be, for example, a chrome mark in the shape of, for example, a cross. In this example, the first light illuminates the stamp, as described above. Just as in the example above the combination of the first light and the substrate marker 200 does not result in a maxima at the light sensor 300, so the combination of the first light and the substrate marker in this example does not result in a maxima at the light sensor because there is no diffraction and any (directly) reflected light would not be incident on the light sensor.

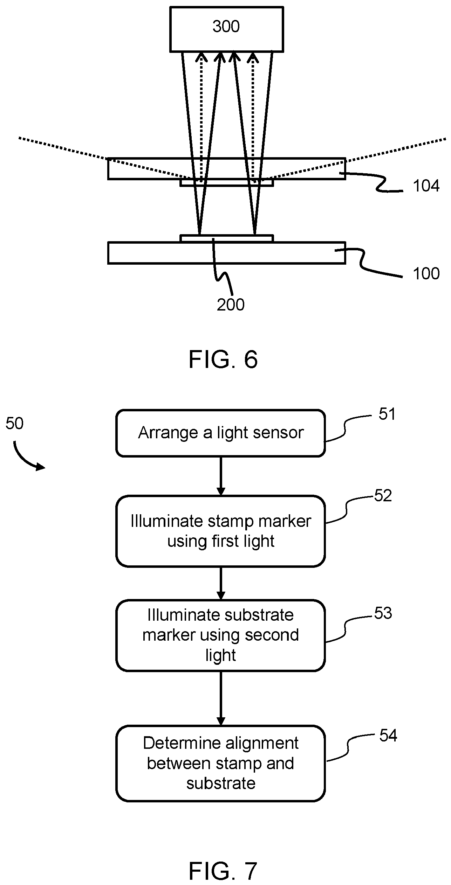

Fig. 6 depicts illumination of the substrate marker 204 by the second light, having a wavelength λ₂ and an incidence angle of θ₂, and the reflection towards the light sensor 300. With the second light incident on the substrate 200 and the stamp 104 little, or no, light would be reflected from the stamp marker 204 towards the light sensor because the stamp marker is not reflective.

The light sensor 300 may detect intensity of the redirected light but a further example of a light sensor is an image sensor which detects the position of the peak of the redirected light. Determining the alignment between the stamp and the substrate comprises processing the image at the image sensor from the first light and the image at the image sensor from the second light.

A lithographic process may comprise the steps of aligning the substrate and stamp, imprinting a pattern on the substrate or a substance thereon, etching the substrate. A lithographic process may comprise these (or more) steps several times, each with a different pattern.

Fig. 7 illustrates a method 50 according to an embodiment. According to an example of the invention there is a method of determining alignment between a stamp 104 and a substrate 100 in a substrate conformal imprint lithography process. The stamp 104 comprises a stamp marker 204 comprising a first diffraction grating with a first period and the substrate comprises a substrate marker 200 on the surface of the substrate. The method comprises arranging 51 a light sensor substantially perpendicularly to the stamp and substrate and illuminating 52 the stamp marker 204 with a first light. The substrate marker is then illuminated 53 with a second, different light.

The first light and the stamp marker 204 are together configured such that more than a first fraction of any of the first light incident upon the stamp marker 204 is redirected towards the light sensor 300. The first light and the substrate marker are together configured such that less than a second fraction of any of the first light incident upon the substrate marker 200 is redirected towards the light sensor.

The second light and the substrate marker are together configured such that more than a third fraction of any of the second light incident upon the substrate marker is redirected towards the light sensor 300. The second light and the stamp marker 204 are together configured such that less than a fourth fraction of any of the second light incident upon the stamp marker 204 is redirected towards the light sensor.

The first fraction is at least two times greater, and preferably five times greater, than the second fraction and the third fraction is at least two times greater, and preferably five times greater, than the fourth fraction.

The alignment between the stamp and the substrate is then determined in step 54 using the response of the light sensor to redirected first light and redirected second light.

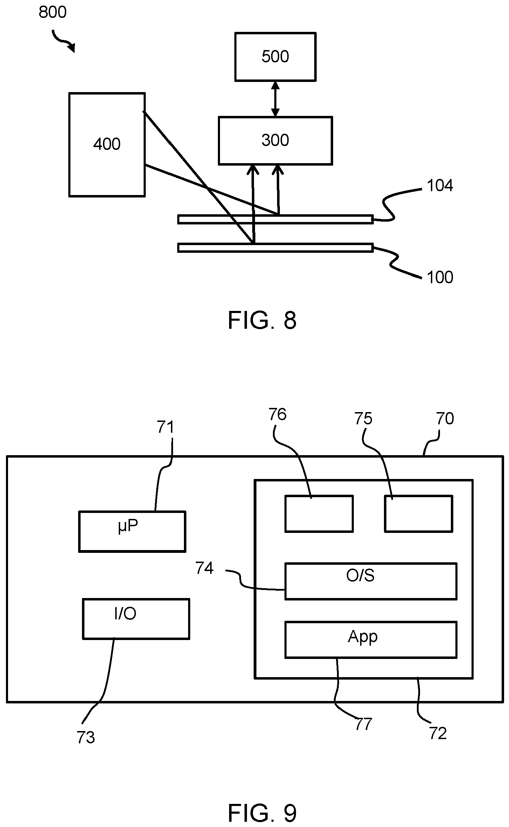

Fig. 8 illustrates an alignment system 800 according to an embodiment.

The alignment system 800 is for aligning a substrate 100 and a stamp 104 in a substrate conformal imprint lithography process. The stamp comprises a stamp marker formed by a diffraction grating, having a first period, on a surface of the stamp and the substrate comprises a substrate marker on the surface of the substrate. The alignment system comprises a light sensor 300 arranged to be substantially perpendicular to the stamp 104 and substrate 100, a lighting system 400, and a processing system 500.

The lighting system 400 is configured to perform steps of illuminating the stamp marker 204 with a first light and illuminating the substrate marker 200 with a second, different light.

The first light and the stamp marker 204 are together configured such that more than a first fraction of any of the first light incident upon the stamp marker is redirected towards the light sensor 300. The first light and the substrate marker 200 are together configured such that less than a second fraction of any of the first light incident upon the substrate marker 200 is redirected towards the light sensor 300 and the first fraction is at least two times greater than the second fraction.

The second light and the substrate marker 200 are together configured such that more than a third fraction of any of the second light incident upon the substrate marker 200 is redirected towards the light sensor 300. The second light and the stamp marker 204 are together configured such that less than a fourth fraction of any of the second light incident upon the stamp marker is redirected towards the light sensor 300. The third fraction is at least two times greater than the fourth fraction.

The processing system 500 is communicatively coupled to the light sensor 300 and configured to process the response of the light sensor to redirected first light and redirected second light to determine an alignment between the stamp and the substrate.

The processing system of the alignment system may be configured to control the operation of the lighting system 400 and/or the light sensor 300 to control the alignment system in performing the defined functions.

The invention may also be embodied in a computer program comprising computer program code means which is adapted, when executed by the alignment system described above, to implement the method as described above.

Fig. 7 illustrates an example of a computer 70 within which one or more parts of an embodiment may be employed. Various operations discussed above may utilize the capabilities of the computer 70. For example, one or more parts of a system for providing a subject-specific user interface may be incorporated in any element, module, application, and/or component discussed herein. In this regard, it is to be understood that system functional blocks can run on a single computer or may be distributed over several computers and locations (e.g. connected via internet), such as a cloud-based computing infrastructure.

The computer 70 includes, but is not limited to, PCs, workstations, laptops, PDAs, palm devices, servers, storages, and the like. Generally, in terms of hardware architecture, the computer 70 may include one or more processors 71, memory 72, and one or more I/O devices 73 that are communicatively coupled via a local interface (not shown). The local interface can be, for example but not limited to, one or more buses or other wired or wireless connections, as is known in the art. The local interface may have additional elements, such as controllers, buffers (caches), drivers, repeaters, and receivers, to enable communications. Further, the local interface may include address, control, and/or data connections to enable appropriate communications among the aforementioned components.

The processor 71 is a hardware device for executing software that can be stored in the memory 72. The processor 71 can be virtually any custom made or commercially available processor, a central processing unit (CPU), a digital signal processor (DSP), or an auxiliary processor among several processors associated with the computer 70, and the processor 71 may be a semiconductor based microprocessor (in the form of a microchip) or a microprocessor.

The memory 72 can include any one or combination of volatile memory elements (e.g., random access memory (RAM), such as dynamic random access memory (DRAM), static random access memory (SRAM), etc.) and non-volatile memory elements (e.g., ROM, erasable programmable read only memory (EPROM), electronically erasable programmable read only memory (EEPROM), programmable read only memory (PROM), tape, compact disc read only memory (CD-ROM), disk, diskette, cartridge, cassette or the like, etc.). Moreover, the memory 72 may incorporate electronic, magnetic, optical, and/or other types of storage media. Note that the memory 72 can have a distributed architecture, where various components are situated remote from one another, but can be accessed by the processor 71.

The software in the memory 72 may include one or more separate programs, each of which comprises an ordered listing of executable instructions for implementing logical functions. The software in the memory 72 includes a suitable operating system (O/S) 74, compiler 76, source code 75, and one or more applications 77 in accordance with exemplary embodiments. As illustrated, the application 77 comprises numerous functional components for implementing the features and operations of the exemplary embodiments. The application 77 of the computer 70 may represent various applications, computational units, logic, functional units, processes, operations, virtual entities, and/or modules in accordance with exemplary embodiments, but the application 77 is not meant to be a limitation.

The operating system 74 controls the execution of other computer programs, and provides scheduling, input-output control, file and data management, memory management, and communication control and related services. It is contemplated by the inventors that the application 77 for implementing exemplary embodiments may be applicable on all commercially available operating systems.

Application 77 may be a source program, executable program (object code), script, or any other entity comprising a set of instructions to be performed. When a source program, then the program is usually translated via a compiler (such as the compiler 76), assembler, interpreter, or the like, which may or may not be included within the memory 72, so as to operate properly in connection with the O/S 74. Furthermore, the application 77 can be written as an object oriented programming language, which has classes of data and methods, or a procedure programming language, which has routines, subroutines, and/or functions, for example but not limited to, C, C++, C#, Pascal, BASIC, API calls, HTML, XHTML, XML, ASP scripts, JavaScript, FORTRAN, COBOL, Perl, Java, ADA, NET, and the like.

The I/O devices 73 may include input devices such as, for example but not limited to, a mouse, keyboard, scanner, microphone, camera, etc. Furthermore, the I/O devices 73 may also include output devices, for example but not limited to a printer, display, etc. Finally, the I/O devices 73 may further include devices that communicate both inputs and outputs, for instance but not limited to, a NIC or modulator/demodulator (for accessing remote devices, other files, devices, systems, or a network), a radio frequency (RF) or other transceiver, a telephonic interface, a bridge, a router, etc. The I/O devices 73 also include components for communicating over various networks, such as the Internet or intranet.

If the computer 70 is a PC, workstation, intelligent device or the like, the software in the memory 72 may further include a basic input output system (BIOS) (omitted for simplicity). The BIOS is a set of essential software routines that initialize and test hardware at startup, start the O/S 74, and support the transfer of data among the hardware devices. The BIOS is stored in some type of read-only-memory, such as ROM, PROM, EPROM, EEPROM or the like, so that the BIOS can be executed when the computer 70 is activated.

When the computer 70 is in operation, the processor 71 is configured to execute software stored within the memory 72, to communicate data to and from the memory 72, and to generally control operations of the computer 70 pursuant to the software. The application 77 and the O/S 74 are read, in whole or in part, by the processor 71, perhaps buffered within the processor 71, and then executed.

When the application 77 is implemented in software it should be noted that the application 77 can be stored on virtually any computer readable medium for use by or in connection with any computer related system or method. In the context of this document, a computer readable medium may be an electronic, magnetic, optical, or other physical device or means that can contain or store a computer program for use by or in connection with a computer related system or method.

The application 77 can be embodied in any computer-readable medium for use by or in connection with an instruction execution system, apparatus, or device, such as a computer-based system, processor-containing system, or other system that can fetch the instructions from the instruction execution system, apparatus, or device and execute the instructions. In the context of this document, a "computer-readable medium" can be any means that can store, communicate, propagate, or transport the program for use by or in connection with the instruction execution system, apparatus, or device. The computer readable medium can be, for example but not limited to, an electronic, magnetic, optical, electromagnetic, infrared, or semiconductor system, apparatus, device, or propagation medium.

The proposed image capture and/or processing methods, may be implemented in hardware or software, or a mixture of both (for example, as firmware running on a hardware device). To the extent that an embodiment is implemented partly or wholly in software, the functional steps illustrated in the process flowcharts may be performed by suitably programmed physical computing devices, such as one or more central processing units (CPUs) or graphics processing units (GPUs). Each process - and its individual component steps as illustrated in the flowcharts - may be performed by the same or different computing devices. According to embodiments, a computer-readable storage medium stores a computer program comprising computer program code configured to cause one or more physical computing devices to carry out an encoding or decoding method as described above when the program is run on the one or more physical computing devices.

Storage media may include volatile and non-volatile computer memory such as RAM, PROM, EPROM, and EEPROM, optical discs (like CD, DVD, BD), magnetic storage media (like hard discs and tapes). Various storage media may be fixed within a computing device or may be transportable, such that the one or more programs stored thereon can be loaded into a processor.

To the extent that an embodiment is implemented partly or wholly in hardware, the blocks shown in the block diagrams of Figs. 1 and 5 may be separate physical components, or logical subdivisions of single physical components, or may be all implemented in an integrated manner in one physical component. The functions of one block shown in the drawings may be divided between multiple components in an implementation, or the functions of multiple blocks shown in the drawings may be combined in single components in an implementation. Hardware components suitable for use in embodiments of the present invention include, but are not limited to, conventional microprocessors, application specific integrated circuits (ASICs), and field-programmable gate arrays (FPGAs). One or more blocks may be implemented as a combination of dedicated hardware to perform some functions and one or more programmed microprocessors and associated circuitry to perform other functions.

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. If a computer program is discussed above, it may be stored/distributed on a suitable medium, such as an optical storage medium or a solid-state medium supplied together with or as part of other hardware, but may also be distributed in other forms, such as via the Internet or other wired or wireless telecommunication systems. If the term "adapted to" is used in the claims or description, it is noted the term "adapted to" is intended to be equivalent to the term "configured to". Any reference signs in the claims should not be construed as limiting the scope.

The flowchart and block diagrams in the Figures illustrate the architecture, functionality, and operation of possible implementations of systems, methods, and computer program products according to various embodiments of the present invention. In this regard, each block in the flowchart or block diagrams may represent a module, segment, or portion of instructions, which comprises one or more executable instructions for implementing the specified logical function(s). In some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

## Claims

1. A method of determining alignment between a stamp and a substrate in an imprint process, wherein the stamp comprises a stamp marker comprising a first diffraction grating, having a first period, on a surface of the stamp and the substrate comprises a substrate marker on the surface of the substrate, wherein the method comprises:
using a light sensor for capturing marker light at an angle to the stamp and substrate;
illuminating at least the stamp marker with a first light, wherein:
the first light and the stamp marker are configured such that more than a first fraction of the first light is directed by the stamp marker towards the light sensor;
the first light and the substrate marker are configured such that less than a second fraction of the first light incident upon the substrate marker is directed towards the light sensor, wherein the first fraction is greater than the second fraction;
illuminating at least the substrate marker with a second, light, different from the first light wherein:
the second light and the substrate marker are configured such that more than a third fraction of the second light is directed by the stamp marker towards the light sensor;
the second light and the stamp marker are configured such that less than a fourth fraction of the second light is directed towards the light sensor, wherein the third fraction is greater than the fourth fraction; and
using the response of the light sensor caused by the directed first light and second light to determine an alignment between the stamp and the substrate.

2. The method according to claim 1, wherein the first fraction is at least two or at least five times greater than the second fraction and/or the third fraction is at least two or at least five times greater than the fourth fraction.

3. The method according to claim 1 or 2, wherein the substrate marker is a contrast marker configured to reflect a portion of the second light to the light sensor.

4. The method according to claim 1 or 2, wherein the substrate marker comprises a diffraction grating having a second period.

5. The method according to claim 4, wherein the first period and the second period are different.

6. The method according to claim 5, wherein the larger of the first period and the second period is at least 20% greater than the smaller of the first period and the second period.

7. The method according to any of claims 4 to 7, wherein the first period is less than the second period.

8. The method according to any one of claims 4 to 7, wherein the step of illuminating at least the substrate marker with the second light comprises illuminating the substrate marker with light having a wavelength and incident angle such that light at the first or higher diffraction order is incident upon the light sensor.

9. The method according to any one of the preceding claims, wherein the first light has a peak intensity at a first wavelength and the second light has a peak intensity at a second, different wavelength.

10. The method according to any one of the preceding claims, wherein the step of illuminating the stamp marker with a first light comprises illuminating the stamp marker with light having a wavelength and incident angle such that light at the first or higher diffraction order is incident upon the light sensor.

11. The method according to any one of the preceding claims, wherein the step of illuminating at least the stamp marker with the first light is performed at a different time to the step of illuminating at least the substrate marker with the second light.

12. The method according to any one of the preceding claims, wherein:
the step of illuminating at least the stamp marker with the first light is performed for a first period of time; and
the step of illuminating at least the substrate marker with the second light is performed for a second period of time, wherein the lengths of the first period of time and the second period of time are different.

13. The method according to any one of the preceding claims, wherein:
the light sensor is an image sensor; and
the step of using the response of the light sensor to determine an alignment between the stamp and the substrate comprises determining the alignment by processing the image at the image sensor from the first light and the image at the image sensor from the second light.

14. An alignment system for determining an alignment between a stamp and a substrate in an imprint process, wherein the stamp comprises a stamp marker comprising a first diffraction grating, having a first period, on a surface of the stamp and the substrate comprises a substrate marker on the surface of the substrate, wherein the alignment system comprises:
a light sensor for capturing marker light at an angle to the stamp and substrate;
a lighting system for :
illuminating at least the stamp marker with a first light, wherein:
the first light and the stamp marker are configured such that more than a first fraction of the first light is directed by the stamp marker towards the light sensor;
the first light and the substrate marker are configured such that less than a second fraction of the first light is directed by the substrate marker towards the light sensor, wherein the first fraction is greater than the second fraction; and
illuminating at least the substrate marker with a second light different from the first light, wherein:
the second light and the substrate marker are configured such that more than a third fraction the second light is directed by the substrate marker towards the light sensor;
the second light and the stamp marker are configured such that less than a fourth fraction of the second light is directed by the stamp marker towards the light sensor, wherein the third fraction is greater than the fourth fraction; and
a processing system communicatively coupled to the light sensor for processing the response of the light sensor caused by the directed first light and second light to determine an alignment between the stamp and the substrate.

15. A computer program product comprising computer program code means which, when executed by the alignment system of claim 14, causes the alignment system to perform all of the steps of the method according to any of claims 1 to 13.
